# EUROPEAN PATENT APPLICATION

(11) **EP 4 428 567 A1**
(43) Date of publication of application: **11.09.2024**
(21) Application number: 24162108.5
(22) Date of filing: 07.03.2024
(51) Int. Cl.: G01S 7/481, G01S 7/4863, G01S 17/89

(54) **SYSTEMS AND METHODS FOR INTERFACING SENSOR DEVICES**

(30) Priority: 07.03.2023 US 202318180123
(71) Applicant: Avago Technologies International Sales Pte. Limited, Singapore 768923 (SG)
(72) Inventor: Mitrovic, Mladen, 1110 Vienna (AT); Gaberl, Wolfgang, 1220 Vienna (AT); Steinle, Gunther, 93051 Regensburg (DE); Davidovic, Milos, 1110 Vienna (AT)
(74) Representative: Dilg, Haeusler, Schindelmann Patentanwaltsgesellschaft mbH

(57) **Abstract**

The present invention is directed to electrical circuits. In a specific embodiment, a first interface circuit is coupled to a first plurality of ports for processing signals at a first frequency range, and a second interface circuit is coupled to a second plurality of ports for processing signals at a second frequency range. The first interface circuit is coupled to a timing channel circuit. The second interface circuit is coupled to an energy channel circuit. There are other embodiments as well.

## Description

### FIELD OF THE INVENTION

The present invention is directed to electrical circuits.

### BACKGROUND OF THE INVENTION

Time-of-flight (ToF) is a method used for measuring the distance between a sensor and an object. It operates by measuring the time it takes for a light or sound pulse to travel from the sensor to the object and back. The travel time is then used to calculate the distance to the object. ToF technology has a wide range of applications, such 3D imaging for objects and environments, distance measurements (e.g., via lidar), security systems for facial and gesture recognition, medical imaging-such as positron emission tomography (PET) scanner-for creating 3D images, and other applications.

Systems for ToF applications utilize specialized sensors. A front-end circuit is a circuit that acts as an interface between a sensor (e.g., detectors used in a positron emission tomography scanner, single-photon avalanche diodes in a lidar, etc.) and the main processing unit or data acquisition system. For example, a front-end circuit is responsible for receiving, amplifying, filtering, and converting the raw signal from the sensor into a digital or analog signal that can be easily processed and analyzed by the processing unit. The front-end circuit can also provide power to the sensor, stabilize its performance, and reduce noise and interference. It is an important component of sensor systems and plays a vital role in ensuring accurate and reliable sensor readings.

Over the past, various types of interface mechanisms and front-end circuits have been proposed, but they were inadequate for reasons explained below.

### BRIEF DESCRIPTION OF THE DRAWINGS

Figure 1 is a simplified block diagram of a front-end circuit connection with a pixel array of a detector according to embodiments of the present invention.
Figure 2 is a simplified block diagram of a front-end circuit according to embodiments of the present invention.
Figure 3 shows intensity versus time plots of typical event pulse and split-band approach outputs of high-band and low-band signal components.
Figure 4 is a simplified block diagram of a system-on-chip circuit according to an embodiment of the present invention.
Figure 5 is a simplified block diagram of a split-chip circuit according to an embodiment of the present invention.
Figure 6 is a simplified block diagram of multiple front-end circuits sharing one central evaluation circuit according to an embodiment of the present invention.
Figure 7 is a simplified flow diagram of a method for timing and energy extraction according to embodiments of the present invention.

### DETAILED DESCRIPTION OF THE INVENTION

The present invention is directed to electrical circuits. In a specific embodiment, a first interface circuit is coupled to a first plurality of ports for processing signals at a first frequency range, and a second interface circuit is coupled to a second plurality of ports for processing signals at a second frequency range. The first interface circuit is coupled to a timing channel circuit. The second interface circuit is coupled to an energy channel circuit. There are other embodiments as well.

In many ToF applications, not only is the timing signal measured accurately for extracting distance or location information, but the energy level is also important in order to discriminate valid signals from background noise or even to provide direct detection of material properties of the location-bound target. For example, ToF technology has the ability to provide both accurate distance and energy information, making it a versatile and powerful tool for various application.

As mentioned above, conventional interfacing mechanisms for ToF applications are inadequate. For example, the conventional technique employs either discrete architectures and separate signal paths, to separately detect timing, and energy of a signal, or using a single high bandwidth channel, which oversamples the signal and delivers both timing and amplitude information and requires higher power consumption as well as the need of very fast analog-to-digital converters (ADCs). New and improved system and method are desired.

In a multi-channel direct Time-of-Flight (ToF) system, it is essential to evaluate both the timing and energy levels of detected event pulses. This is necessary to search for and select events associated with the detection of specific incident optical signals that possess a specific energy and pulse shape. For instance, in positron emission tomography (PET) scanners that use arrays of silicon photomultipliers (SiPM), the energy level is important for distinguishing valid signals from background noise. Typically, only events within a certain range close to the 511 keV energy of interest are taken into account. Evaluating the energy information of the event pulse must be done in combination with determining its location. In the case of a multichannel lidar sensor that utilizes an arrays of SiPM or avalanche photo detectors (APD), accurate and robust distance extraction is an important concern. However, accurate energy information would also be beneficial in discriminating the material properties of objects along with the quality of the signal itself.

Most multi-channel direct ToF systems utilize time-to-digital converters (TDC) to determine distance values. However, these converters do not yield the energy or amplitude levels of the signals. To fully process the response signals, including time and amplitudes, multi-channel high-speed analog-to-digital converters (ADC) can be used. But processing a large number of samples per pulse and channel, as well as the power consumption of many channels, becomes a critical issue.

Gaining a better understanding of the timing and energy signal features in a multi-channel direct ToF system can help identify an optimal front-end architecture that optimizes power consumption while accurately evaluating timing and energy levels. Taking PET applications as an example, this system detects an event optical pulse when a gamma photon interacts with the detector, using the ToF principle to pinpoint the event's location. A typical timing precision of 50ps is required for a normal distribution. For lidar applications, the time between the laser pulse being sent out and the reflected pulse being detected is multiplied by the speed of light, equating to double the distance of the object. The SOps timing precision would yield a 7.5mm distance precision. Conversely, the energy signal is the intensity over time generated by a SiPM or APD detector during the detection event and is measured by integrating the event pulse over time. Typically, the energy precision must be within the single-digit percent range.

The present disclosure presents a front-end architecture that aims to provide both accurate timing and energy signals for each detected pulse by using a high-speed TDC sample for timing and a low-speed ADC sample for energy per pulse and channel. It also allows for a flexible selection of a varying number of channels for timing and energy or localization classification.

For example, in a PET scanner with a low incident rate, a single timing channel would be sufficient for classification; however, all pixel energies and locations should be monitored. In contrast, for a lidar sensor, the number of channels can be tailored to the scenario. For instance, if the laser is only illuminating a fraction of the pixels at a certain time, the number of channels for energy classification can be lower than the number of channels required for TOF distance measurements.

A split-band approach offers more flexibility in optimizing the overall system performance and allows for a more efficient use of resources, and enables the system to adapt to different scenarios, providing a better performance in terms of power consumption and accuracy.

The following description is presented to enable one of ordinary skill in the art to make and use the invention and to incorporate it in the context of particular applications. Various modifications, as well as a variety of uses in different applications will be readily apparent to those skilled in the art, and the general principles defined herein may be applied to a wide range of embodiments. Thus, the present invention is not intended to be limited to the embodiments presented, but is to be accorded the widest scope consistent with the principles and novel features disclosed herein.

In the following detailed description, numerous specific details are set forth in order to provide a more thorough understanding of the present invention. However, it will be apparent to one skilled in the art that the present invention may be practiced without necessarily being limited to these specific details. In other instances, well-known structures and devices are shown in block diagram form, rather than in detail, in order to avoid obscuring the present invention.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent, or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

Additionally, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

Please note, if used, the labels left, right, front, back, top, bottom, high, low, forward, reverse, clockwise and counterclockwise have been used for convenience purposes only and are not intended to imply any particular fixed direction. Instead, they are used to reflect relative locations and/or directions between various portions of an object. For example, a feature of "high-speed" or "fast" described in this specification is referred to as high frequency or a high-band of frequencies above a reference frequency value. Also, "low-speed" or "slow" is referred to low frequency or a low-band of frequencies below a reference frequency value.

In an exemplary embodiment, the present invention provides an apparatus configured as an interfacing circuit that includes a first plurality of input ports coupled to a first plurality of channels configured to receive a first plurality of input signals. The circuit also includes a second plurality of input ports coupled to a second plurality of channels configured to receive a second plurality of input signals. The circuit also includes a first interface circuit configured to extract first signal components in a first bandwidth from the first plurality of input signals and output a first intermediate signal. As an example, for "fast channel", it may be advantageous to implement a high-pass filter or a circuit that functions as a high-pass filter. In certain implementations, for the energy channel, a bandpass filter may be preferable over a DC-coupled low-pass filter to effectively eliminate unwanted noise, such as ambient light. It is to be appreciated that power saving and noise reduction can be achieved by implementing energy channels having a smaller total bandwidth compared to the total band bandwidth of the timing channels. The circuit also includes a second interface circuit configured to extract second signal components in a second bandwidth from second plurality of input signals and output a plurality of second intermediate signals, the second bandwidth having a smaller and lower frequency band than the first bandwidth. The circuit also includes a first channel circuit coupled to the first interface circuit and configured to process the first intermediate signal. The circuit also includes a second channel circuit coupled to the second interface circuit and configured to process the plurality of second intermediate signals.

Implementations may include one or more of the following features. The first plurality of channels of the interface circuit may include M channels selected from 1 to N, N being a number of all input ports. The second plurality of channels may include L channels selected from 1 to N. M and L are independent whole numbers. The first plurality of input signals is associated with a pulse detected by an array of N detectors respectively connected to N input ports. The second plurality of input signals is associated with the pulse. The plurality of second intermediate signals may include the second signal components associated with from the L channels. The energy channel circuit may include L integral amplifiers, each of the L integral amplifiers being configured to integrate the second signal components over a time period. The first interface circuit may include a high-pass filter and a multiplexer. The high-pass filter is configured in series with the input ports to extract the first signal components from the M channels. The multiplexer is configured to sum up the first signal components for the M channels. The high-pass filter may include a capacitor characterized by a capacitance value associated with the first bandwidth. The second interface circuit and the first interface circuit are configured in parallel with one another. The first channel circuit may include a trans-impedance amplifier for converting the first intermediate signal to a voltage signal. The second interface circuit may include a DC-coupling circuit configured to as a low-pass filter to filter out frequencies above the second bandwidth of the second plurality of input signals to obtain the second signal components. The second interface circuit includes a bandpass filter to filter out frequencies beyond the second bandwidth of the second plurality of input signals to obtain the second signal components. The interfacing circuit may include a first evaluation circuit coupled to the first channel circuit. The first evaluation circuit may include at least a time-to-digital converter operating at a first frequency range. The first frequency range is based on the first bandwidth. A second evaluation circuit is coupled to the second channel circuit. The second evaluation circuit may include a plurality of analog-to-digital converters operating at a second frequency range. The second frequency range is based on the second bandwidth. A digital logic circuit may include a digital signal processor or field-programmable gate array circuit configured to extract timing information associated with the pulse based on outputs of the first evaluation circuit and extract energy information associated with the pulse based on outputs of the second evaluation circuit. The plurality of analog-to-digital converters are configured as a multi-channel analog-to-digital converter having a number of channels equal to total number of the second plurality of channels. The interfacing circuit may include a channel interface coupled to the first evaluation circuit and the second evaluation circuit. Implementations of the described techniques may include hardware, a method or process, or computer software on a computer-accessible medium.

According to another embodiment, the present invention provides an apparatus that includes one or more front-end devices configured to couple to a respective of one or more arrays of detectors, each of the front-end devices may include a first plurality of input ports coupled to a first plurality of channels configured to receive a first plurality of input signals based on a pulse detected by a respective one of the one or more arrays of detectors. Each of the front-end devices may also include a second plurality of input ports coupled to a second plurality of channels configured to receive a second plurality of input signals based on the detected pulse. Each of the front-end devices may also include a first interface circuit configured to extract first signal components in a first bandwidth of the first plurality of input signals and output a first intermediate signal. Each of the front-end devices also includes a second interface circuit configured to extract second signal components in a second bandwidth of the second plurality of input signals and to output a plurality of second intermediate signals, the second bandwidth having a smaller and lower frequency band than the first bandwidth. Each of the front-end devices may also include a first channel circuit coupled to the first interface circuit and configured to process the first intermediate signal; and a second channel circuit coupled to the second interface circuit and configured to process the plurality of second intermediate signals. The apparatus also includes a central evaluation device coupled to the one or more front-end devices. The central evaluation device may include a first evaluation circuit may include at least a time-to-digital converter (TDC) configured to evaluate timing information associated with the pulse using at least an output of the first channel circuit of a respective one of the one or more front-end devices. The central evaluation device may also include a second evaluation circuit may include at least the second plurality of analog-to-digital circuits (ADCs) configured to evaluate energy information associated with the pulse using at least a plurality of outputs of the second channel circuit of the respective one of the one or more front-end devices. The central evaluation device may also include a digital logic circuit coupled to the first evaluation circuit and the second evaluation circuit configured to extract the timing information and the energy information associated with the pulse.

Implementations may include one or more of the following features. The central evaluation device and one or more front-end devices operate asynchronously. Optionally, the one or more front-end devices and the central evaluation device are separate chip components configured on a single printed circuit board. Optionally, the one or more front-end devices and the central evaluation device are components in a system-on-chip package. Implementations of the described techniques may include hardware, a method or process, or computer software on a computer-accessible medium.

According to yet another embodiment, the present invention provides a method for obtaining timing and energy information. The method also includes receiving a first plurality of input signals associated with a pulse detected by an array of detectors. The method also includes receiving a second plurality of input signals associated with the detected pulse. The method also includes obtaining a first signal component for each of the first plurality of input signals and outputting a first intermediate signal, the first signal component being associated with a first bandwidth. The method also includes obtaining a second signal component for each of the second plurality of input signals and outputting a plurality of second intermediate signals, the second signal component being associated with a second bandwidth, the second bandwidth having a smaller and lower frequency band than the first bandwidth. The method also includes processing the first intermediate signal by a timing channel circuit, the first intermediate signal being characterized by a first frequency range, the first frequency range being based on the first bandwidth. The method also includes processing the plurality of second intermediate signals by an energy channel circuit, the plurality of second intermediate signals being characterized by a second frequency range, the second frequency range being based on the second bandwidth. The method also includes evaluating timing information associated with the detected pulse using at least an output of the timing channel circuit and energy information associated with the detected pulse using at least outputs of the energy channel circuit.

Implementations may include one or more of the following features. The method may include amplifying the first intermediate signal by a transimpedance amplifier. The method may include filtering the first plurality of input signals. For example, the transimpedance amplifier provides a voltage signal whose magnitude is based on (e.g., proportional to) an input current, but other configurations are possible as well.

It is to be appreciated that embodiments of the present invention provide many advantages over conventional techniques. In various implementations, one-silicon design of a front-end circuit on ASIC chip can provide better controlled timing and energy performances compared to existing discrete solutions. For example, fewer number of components being used in the system means lower costs. Embodiments of the present invention also provide higher design flexibility to reach a maximum resolution of distance and energy measurements separately, for a given power and processing power budget. For example, using a timing channel circuit and an energy channel circuit configured parallelly as one integrated component on ASIC chip can achieve optimized power consumption for each of them with substantially saving compared to discrete components, not to mention further cost saving on chip cooling system. A single-ASIC design allows for high-speed (or high bandwidth) front-end circuits to share a smaller printed circuit board (PCB) footprint, which may translate to denser design possibilities that could provide higher lateral resolution. In some embodiments, one or more first front-end circuits that are attached only to respective detector arrays (such as silicon photomultipliers, or SiPMs) and decouple it from other circuitry that is not working synchronously with event detection. For example, local ground bouncing of the front-end amplifier can function as infinitely low, which is helpful for low-noise timing detection.

Embodiments of the present invention can be implemented in conjunction with existing systems and processes. For example, context information sharing among applications according to embodiments of the present invention may be implemented according in various operating systems. Additionally, various techniques according to the present invention can be adopted into existing systems via software installation and updates. There are other benefits as well.

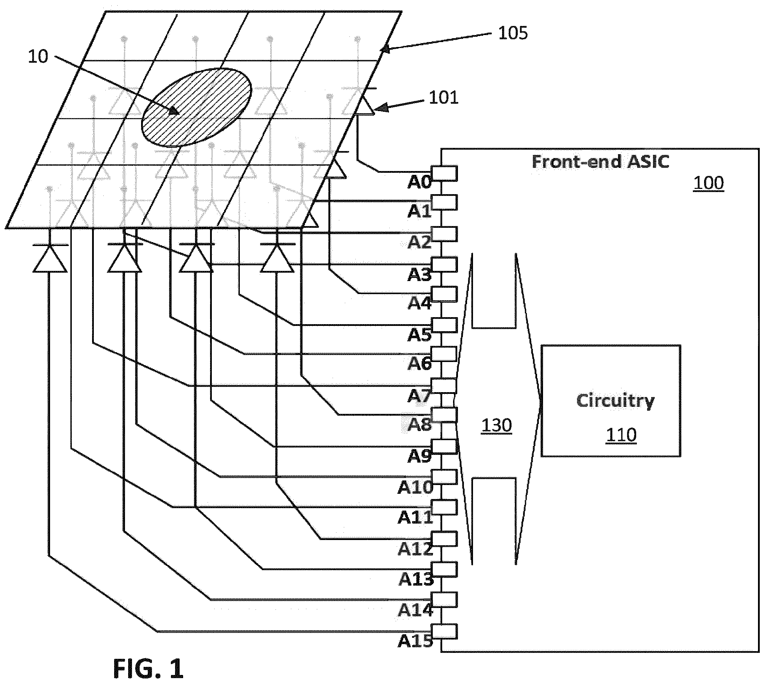

Figure 1 is a simplified block diagram of a front-end circuit connection with a pixel array of a detector according to embodiments of the present invention. This diagram is merely an example, which should not unduly limit the scope of the claims. One of ordinary skill in the art would recognize many variations, alternatives, and modifications. A front-end device, in the context of electronic systems, is a component or module that is responsible for receiving, amplifying, and conditioning the incoming signals before they are processed by the rest of the system. As an example, the term "front-end" device refers to an interface device or circuit that provides an interface between a sensor (e.g., a lidar sensor, or a PET detector, etc.) and data processing circuits. In various implementations, the front-end device may be implemented as the first stage of signal processing and is responsible for preparing the signal for further analysis.

Figure 1 provides a front-end block 100 is disposed with multiple input ports connecting to a detector array 105 which detects an event light pulse 10. For example, the term "detector" may refer to detector circuits used in PET scanners or lidar sensors. In an embodiment, front-end block 100 is implemented as-by itself or being a part of-an application specific integrated circuit (ASIC). For example, the type of front-end device used in a system depends on its application. For example, a multi-channel direct time-of-flight system, such as a lidar or a PET scanner, requires a front-end device to receive and process the signals from detectors like SiPM or single-photon avalanche diode (SPAD) circuits. In various implementations, front-end block 100 is capable of processing timing and energy levels with high precision and power efficiency.

Front-end block 100, as shown in Figure 1, includes multiple input ports (e.g. A0-A15) that are connected to pixel diodes 101 associated with multiple pixels in a detector array 105. For example, detector array 105 may be an array of silicon photomultipliers (SiPM), avalanche photo detectors (APD), or other types of photodetectors. For example, detector array 105 may be used in applications such as PET scanners or lidar systems. The multiple input signals, typically converted from optical signals by the incident event light pulse 10, are received by the input ports and processed by an interface circuit 130 before being transferred to the core circuitry 110 of the front-end block 100 for further evaluation and determining the timing and energy of the event pulse, as well as power optimization. For example, event light pulse 10 may be a light pulse emitted by a PET scanner or a lidar system with a known duration and/or pattern and detected by the detector array after the light pulse being reflected from a target, as ToF distance may be calculated as the time difference between of emission and detection of the event light pulse.

As an example, an SiPM implementation may include thousands of single-photon avalanche diodes (SPADs). Connections between the array of detectors and input ports of front-end ASIC 100 are configured parallel (e.g., components are connected across each other such that they have separate and distinct paths for electric current to flow) with capability of detecting low light levels (e.g., represented by a few photons) and up to a high level (e.g., limited by a recharge time and the number of SPAD pixels).

The incident optical signal, representing an event pulse of interest, may be detected by multiple pixels simultaneously (e.g., event light pulse 10 detected by four pixels in Figure 1). Each pixel would generate an electrical response proportional to the magnitude of the detected optical signal. The sum of these detector signals is combined by the front-end device, which has multiple input ports (e.g., input ports A0 to A15) coupled to the respective pixels (e.g., 16 detectors in Figure 1). To achieve the high-precision timing to within a double digital picosecond accuracy required for detecting the rising edge of the signals (e.g., the timing bandwidth of circuitry 110 needs to be in the range of hundreds of MHz), the front-end device requires high-speed and precise signal processing capabilities. The front-end device of the present disclosure is capable of providing the total event pulse and accurate energy and location information, while shielding the system from noise and interference to ensure a high signal-to-noise ratio for accurate measurement. Additionally, the front-end device of the present disclosure is designed to operate at low power consumption, allowing for efficient and portable system implementations.

Furthermore, the energy levels of the signal should be determined, as well as the positions of the event pulse 10 in the array of detectors 105. For example, the front-end block 100 can resolve the proportion of detectors or pixels that contributed to the total event pulse. In various applications, an electrical signal produced by a detector lasts some hundreds of nanoseconds; consequently, the energy bandwidth of the circuit that needs to detect the energy must be in the lower two-digit MHz range and much smaller than the timing bandwidth. To effectively extract both timing and energy information from the signals, a split-band approach can be employed, wherein different circuits are used for different frequency bands and optimized circuits for each band are employed individually.

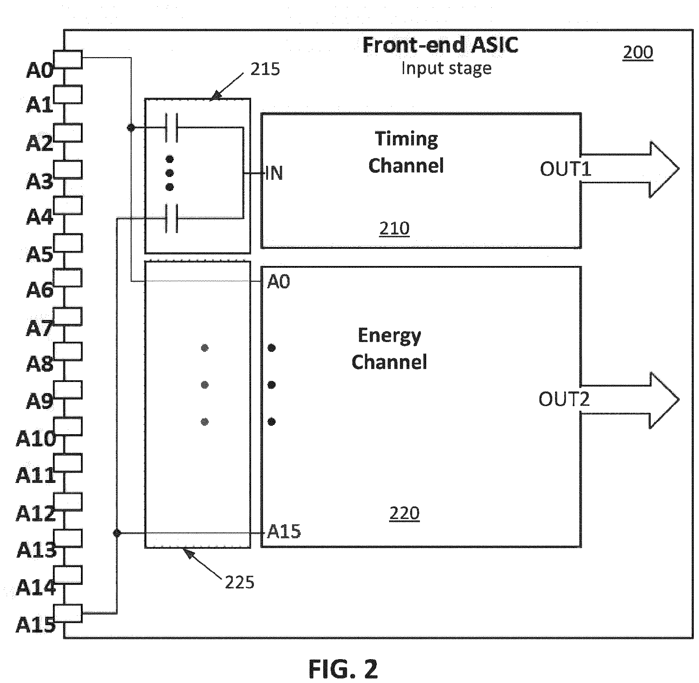

Figure 2 is a simplified block diagram of a front-end circuit according to embodiments of the present invention. This diagram is merely an example and should not be used to limit the scope of the claims. As an embodiment, a front-end device 200 is an input stage of an ASIC that uses the split-band approach to accurately extract both timing and energy information. This device has sixteen input ports, A0 to A15, that receive signals induced by an event pulse detected by an array of detectors.

The front-end circuit 200 includes a first interface circuit 215 and a second interface circuit 225 that are connected to the multiple input ports. Each port is associated with a channel of the interface. The first interface circuit 215 processes the input signal from each input port and obtains a high-band signal component in a limited bandwidth that carries all features associated with signal rising edge, which is directly related to evaluate timing information about the event pulse through a ToF measurement. The first interface circuit 215 outputs a first intermediate signal to a timing channel circuit 210. For example, the high-band signal component is referred to a part of the input signal being filtered by a high-pass filter with a low bound frequency. The high-band signal retains only frequencies of the input signal above the low bound frequency. The first interface circuit 215 also processes all the high-band signal components by summing up them to output a first intermediate signal. Thus, the first intermediate signal also has a frequency spectrum higher than the low bound frequency. The timing channel circuit 210 processes the first intermediate signal to generate an output signal OUT1 that can be used to evaluate the timing information about the event pulse. Working in parallel to the first interface circuit, the second interface 225 processes the input signal from each input port and obtains a low-band signal component in another reduced bandwidth. This bandwidth is selected to remove unwanted noise for evaluating energy information. For example, the reduced bandwidth is obtained by using a low-pass filter to filter out ambient light in higher frequency to obtain the low-band signal component with a high bound frequency. In another example, the reduced bandwidth is obtained by using a bandpass filter to filter out the unwanted noise beyond a lower bound and a higher bound of the bandwidth. In general, the reduced bandwidth associated with the low-band signal has a smaller total bandwidth than the limited bandwidth associated with the high-band signal. The second interface circuit outputs a second intermediate signal per channel to an energy channel circuit 220. The second intermediate signal also is in a frequency range based on the reduced bandwidth selected for evaluating energy information primarily in lower frequencies. The energy channel circuit 220 may process the second intermediate signal to generate an output signal OUT2 for evaluating the energy information about the event pulse. As an example, the term "signal component" refers a selected frequency range of a signal which may have a wider frequency.

The split-band approach is applied to the front-end circuit design in Figure 2 to achieve simultaneous extraction of timing and energy information. The fast front-end circuit, composed of first interface circuit 215 and timing channel circuit 210, is characterized by a high-frequency band associated with a first bandwidth with frequencies of interest greater than 100 MHz for extracting timing information. Parallel to this, the slow front-end circuit, composed of second interface circuit 225 and energy channel circuit 220, is characterized by a low-frequency band associated with a second bandwith with frequencies of interest in the range of 10-30MHz (though this may vary depending on the application). It is to be understood that values and ranges for "high-frequency band" and "low-frequency band" may be changed for different implementations (e.g., detection range, precision requirement, detector sensitivity, etc.). The timing channel circuit 210 may be referred to be a first channel circuit that is designed to handle or process analog signals with a frequency band above a first frequency, e.g., 100 MHz, as timing information (between light pulse emission and its detection) is in ps range. The energy channel circuit 220 may be referred to be a second channel circuit that is separately designed to handle or process analog signals with a frequency band below a second frequency, e.g., 30 MHz, as it is sufficient for capturing almost all intensity integration values in this range.

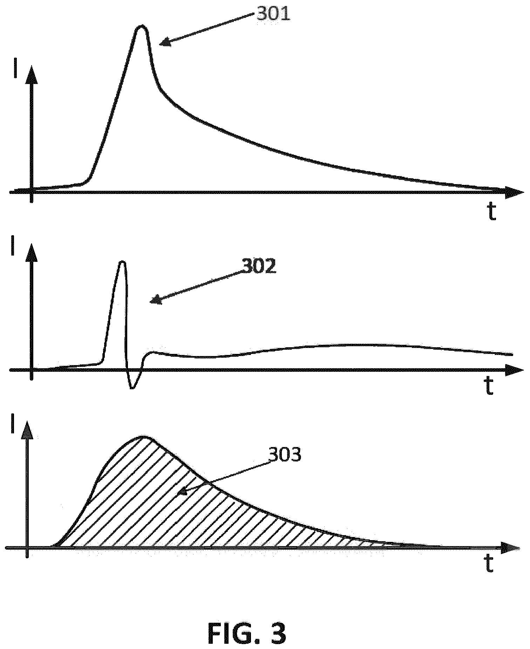

Figure 3 shows intensity vs. time plots of typical event pulse and split-band approach outputs of high- and low-band signal components. Plot 301 shows an intensity profile of a typical detected event pulse. Plot 302 gives a sketch of the output signal (OUT1) of the timing channel circuit, which is peaked around a short (fast) time point as all its frequency components are in a first bandwidth with frequency higher than a low bound frequency, such as 100 MHz. Plot 303 shows the output (OUT2) of the energy channel circuit, which has a broadened time span as most energy information comes with DC components or low-frequency components in a second bandwidth with frequency below a high bound frequency, such as 20 MHz.

The area under the curve of plot 303 yields an integral value of the signal intensity over the time span, which indicates that the split-band approach of splitting the signal path into two paths in different frequency bands is an effective way to accurately extract both timing and energy information. The first bandwidth is selected to keep signal features required for determining its rising edge which is directly used for timing measurement. The second bandwidth can be selected to be smaller and in a lower frequency range than the first bandwidth as main information about energy of the pulse is carried in DC component or low frequency component and noises such as ambient light are in higher frequency. Furthermore, building the front-end circuit in one fast timing path associated with the first bandwidth of high frequencies and one slow energy path associated with the second bandwidth of low frequencies, as shown in Figure 2, allows for each path to be processed by a power-optimized circuit for the corresponding frequency band. The fast timing path allows only fast or high-frequency signal components to pass and be processed to evaluate the timing information and the slow energy path allows only slow or low-frequency signal components to pass and be processed to evaluate the energy information.

In a specific embodiment, the first interface circuit 215 is configured to start the fast timing path for carrying the fast signal component of the input signal by using a high-pass filter as its initial input device, connected to each input port. This high-pass filter can be implemented with integrated capacitors connected in series with the input ports, whose capacitance allows for the adjustment of a low bound frequency. For instance, a first bandwidth is selected with the low bound frequency being in the 100 MHz range. Only signal components faster than this low bound frequency will propagate through the channel into the timing path for the timing detection. However, the energy information of such an event cannot be extracted in this same (e.g., fast) path, as no information on the integral of the signal is available due to the high-pass filtering. The high-pass filter has a much lower input impedance than its output impedance, to ensure an undistorted signal filtration. Using integrated capacitor for the high-pass filter is a widely available approach, for example, with the common complementary MOSFET (e.g., CMOS) integrated circuit technology. Another way, as an example, to implement high-pass filters is by using an active circuit such as an operational amplifier.

The second interface circuit 225 in the slow energy path, which is connected in parallel to the first interface circuit 215 in the fast timing path, is configured to carry the slow or the low-frequency component of the signal in a second bandwith. For example, the low-frequency signal component in the second bandwidth is associated with a high bound frequency (e.g., at around 20 MHz), which is determined based on the nature of the event pulse that is to be detected. This is because the electrical signal produced by SiPMs in response to the event has a decay time of several hundreds of ns, which covers most of the time span shown plot 303 of Figure 3. In a specific embodiment, the second interface circuit 225 includes a DC-coupling circuit with an anode biased by a voltage source, thus only allowing the slow signal components with frequencies below the high bound frequency to enter the energy path for energy evaluation. The high bound frequency of the second bandwidth is selected to be lower than the low bound frequency of the first bandwidth. In another specific embodiment, the second interface circuit 225 includes a bandpass filter to obtain the slow signal components by filter out unwanted noises beyond the second bandwidth and only keeps frequencies carrying the energy information.

For example, the front-end device may not have a dedicated block to receive signals in the frequency range of 20-100 MHz. However, this signal can still be used for further analysis, even though it may not be of interest for the specific application. A circuit block such as a notch filter can be used to discard or process this signal for further analysis. In certain embodiments, front-end functionality can be achieved by using a slow front-end and a fast front-end to discard the unwanted frequency component of the signal. This can be accomplished by implementing appropriate filtering techniques or by using a band-pass filter that allows only the desired frequency range to pass through, while rejecting the undesired frequencies.

The design of a front-end device is dependent on the application and performance requirements. Factors such as signal frequency range, signal-to-noise ratio, and power consumption must be taken into consideration. As depicted in Figure 2, the proposed front-end ASIC design involves the parallel configuration of a fast front-end circuit and slow front-end circuit connected to input ports A0 through A15. The number of channels (in this example is 16) may be limited by circuitry power consumption and the design of the detector pixel array. In some examples, the number of channels is fixed (e.g., equal to the total number of input ports) to match the total number of detectors in the array. Alternatively, the number of channels can be determined flexibly using a channel selector for each of two circuit paths of the front-end circuit, with the number of channels for the timing path being either higher or lower than the number of channels for the energy path. Generally, a higher number of channels increases spatial resolution for detecting the event pulse, however, it also increases the complexity and cost of the circuit design, as well as the power consumption of the system. An implementation illustrated in front-end ASIC 200 can provide a flexible channel selection while implementing the split-band approach.

In a specific embodiment, flexible channel selection can be implemented in both the first interface circuit 215 and second interface circuit 225. For example, each interface circuit may include a channel selector configured to, in parallel, select a certain number of channels from the multiple channels, allowing only signals associated with the selected channels to enter the timing path or the energy path. The channel selector of the first interface circuit 415, for instance, may select a first plurality of channels from the multiple channels. This first plurality of channels may contain any number of channels ranging from 1 to 16 channels, for example, those associated with input ports A0 through A15 in Figure 2.

The first plurality of channels may include a number of channels up to the total number of detectors in the array of detectors. This channel selector may be an integrated switch device, located either before or after the high-pass filter. Additionally, the first interface circuit 215 includes a multiplexer located after the high-pass filter, which multiplex all high-band signal components that have passed through the selected channels. The channel selector of the second interface circuit 225 is used to independently select a second plurality of channels from the multiple channels, ranging from 1 to 16 of A0 through A15. The second plurality of channels may also include a number of channels up to the total number of detectors in the array of detectors. Both the first number and the second number are independent from each other, while no multiplexer is required for the second interface circuit.

In an example, assuming a low incidence rate for the event pulse detected by the pixel array (like those in PET scanner applications), a single timing channel would be sufficient to monitor the energies and locations of each event pulse. The timing information is stable and independent of the intensity, and only the first "firing" pixel or the first couple of "firing" pixels (the first detected photon) will dominate the rise time of the signal (as shown in plot 302 of FIG.3). Therefore, one input signal through one selected channel entering the time path may be sufficient for evaluating the timing information about the event pulse. Moreover, the power consumption of the timing path can be minimized, so that one front-end circuit per SiPM connection may be reserved. Ultimately, the timing information is used to detect the location of the radiation source in the ToF application.

The event pulse of a PET scanner can be spread across one or more SiPMs in the SiPM array. Accurate timing information must be extracted from the SiPM or a combination of several neighboring SiPMs. This means the front-end circuit requires a multiplexer to sum up the signals from all channels simultaneously. For a Lidar sensor, the number of channels selected for timing can be optimized. This can be done similarly if the laser is only illuminating a fraction of the pixels at any given time. Alternatively, the number of channels selected for timing evaluation can be higher than for energy evaluation if the spatial resolution for energy classification is lower than the ToF distance measurements.

The flexible channel selection approach, as described according to embodiments of the present invention, is beneficial for single pixel detector systems. This is because it allows for individual optimization of slow and fast channels. For example, this approach can be used to discriminate multiple reflexes from one event pulse from one or more translucent objects by utilizing several fast channels, while only employing one slow channel to measure the total energy received per event pulse. This technique can be applied to various systems, such as PET scanners, LiDAR applications, or any other system that requires evaluation of both timing and energy of an optical signal hitting one or more optical detectors at the same time. The use of a high number of channels is limited, however, due to computational overhead and power consumption.

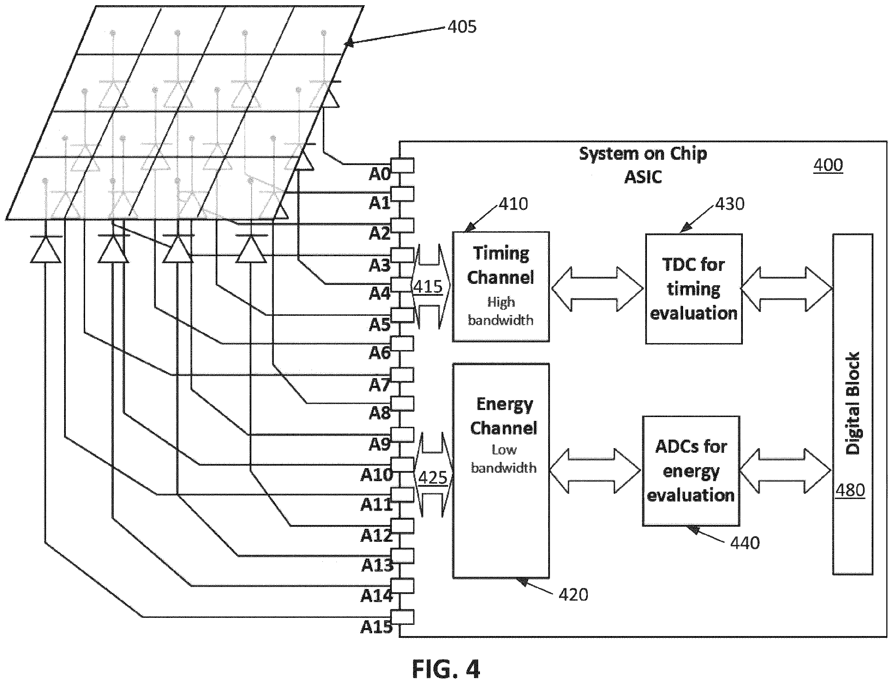

Figure 4 shows a simplified block diagram of a System-on-Chip (SOC) circuit according to an embodiment of the present invention. This diagram serves as an example and should not be taken to limit the scope of the claims. Those with ordinary skill in the art would recognize many variations, alternatives, and modifications. For example, a SOC variant integrates a fast front-end for timing and slow front-ends for energy extraction, much like the front-end input stage shown in Figure 2, together with the evaluation circuitry, like that shown in Figure 1, into a single ASIC chip.

In an embodiment, Figure 4 shows that SOC circuit 400 includes multiple input ports, e.g., A0, ..., A15, which are respectively connected to an array of detectors 405. These detectors are used to detect an optical signal, or event pulse, which can cover multiple detector areas up to the entire array in a saturation situation. Thus, electrical signals converted from the optical signal are received as input signals by at least some, and potentially all, of the multiple input ports. SOC circuit 400 includes a first interface circuit 415, coupled to a timing channel circuit 410 to form a fast front-end path, and a second interface circuit 425, connected to an energy channel circuit 420 to form a slow front-end path. These two front-end paths together form the front-end input stage circuit 200, as shown in Figure 2. First interface circuit 415 is configured to receive a first plurality of input signals from a first plurality of channels selected among the multiple input ports. It also includes a high-pass filter to only allow the high-frequency components in a first bandwidth of the input signals from the selected first plurality of channels to enter timing channel circuit 410 for timing evaluation. Additionally, first interface circuit 410 may include a multiplexer to sum up all high-frequency signal components, outputting a first intermediate signal.

Timing channel circuit 410 may include at least a trans-impedance amplifier for processing the first intermediate signal to generate a first analog output with undistorted amplification. The first plurality of selected channels can contain any number up to all of the multiple channels (i.e., 16 channels as shown), depending on the requirements of the front-end design and the features of the event pulse. In a parallel configuration, second interface circuit 425 is configured to receive a second plurality of input signals from a second plurality of channels chosen from the multiple input ports. This second plurality of channels is completely independent from the first plurality of channels. Second interface circuit 425 also includes a bandpass filter or a low-pass filter such as a DC-coupling circuitry to only allow the low-frequency components in a second bandwidth of the second plurality of input signals from the selected channels to enter the energy channel circuit 420 for evaluation of the energy. The second bandwidth is smaller than the first bandwidth. The second bandwidth has a lower frequency band than the first bandwidth. This channel selection provides a flexible option for optimizing slow front-end design to conserve power consumption. Energy channel circuit 420 may receive up to 16 channels of low-frequency signal components, which are outputted as a second plurality of second intermediate signals from the second interface circuit 425. Energy channel circuit 420 may include an integrator amplifier per channel to convert each of the second plurality of second intermediate signals into a second analog output carrying the energy (e.g., charge) information.

In another embodiment, SOC circuit 400 of Figure 4 integrates evaluation circuitry including at least a first evaluation circuit 430, an ADC circuit 440, and a digital logic circuit 480 on a single ASIC. First evaluation circuit 430 is connected to timing channel circuit 410 to receive the first analog output. This first evaluation circuit 430 contains at least a time-to-digital converter (TDC), which is used to convert the time interval carried in the first analog signal to a digital signal with the timing information. This TDC is high-speed, with bandwidth for frequencies above a low bound frequency (e.g., 100 MHz). Furthermore, only one high-speed TDC is required to process the first analog signal from the fast front-end. ADC circuit 440 is linked to energy channel circuit 420 to receive the second analog output for each selected channel up to all 16 channels. This ADC circuit 440 has multiple analog-to-digital converters (ADCs) which convert multiple second analog signals to digital signals with the energy information.

In an embodiment, each of the multiple analog-to-digital converters is a slow-speed ADC characterized by a bandwidth for frequencies lower than a high bound frequency (e.g., 10 - 30 MHz). Optionally, a multi-channel ADC may be employed to process the multiple analog signals from the slow front-end. Additionally, the digital logic circuit 480 is connected via a channel interface to both the first evaluation circuit 430 and second evaluation circuit 440. As an example, the channel interface refers to a logical interface, such as a software-defined interface, that provides a common communication protocol for exchanging information between the first evaluation circuit 430 and second evaluation circuit 440. The digital logic circuit 480 may include a digital signal processor, field-programmable gate arrays, or other type of a processing unit configured to process digital outputs from both the first evaluation circuit 430 and ADC circuit 440 for extracting both the timing and energy information about the event pulse simultaneously. In an embodiment, this SOC circuit 400 can be used to its fullest potential with silicon-on-insulator (SOI) CMOS / BiCMOS processes, but is also suitable for standard CMOS technologies.

The present disclosure, in various implementations, provides a front-end device to optimize costs and minimize the printed circuit board footprint. For example, this is done by creating an ASIC design with more than one fast front-end circuit. In one embodiment, a chip is presented with four groups of 16-channel slow front-end circuits and one fast front-end circuit per group. This includes 64 slow front-end circuits, i.e., 64 channels connected to the detectors such as SiPMs, divided into four groups for timing extraction. The number of input signals, as well as their grouping, can be highly customized and adapted to a ToF application system such as a PET scanner to enhance performance while remaining within a power consumption budget. This design is best applicable in an SOI process, but can also be realized in a standard CMOS.

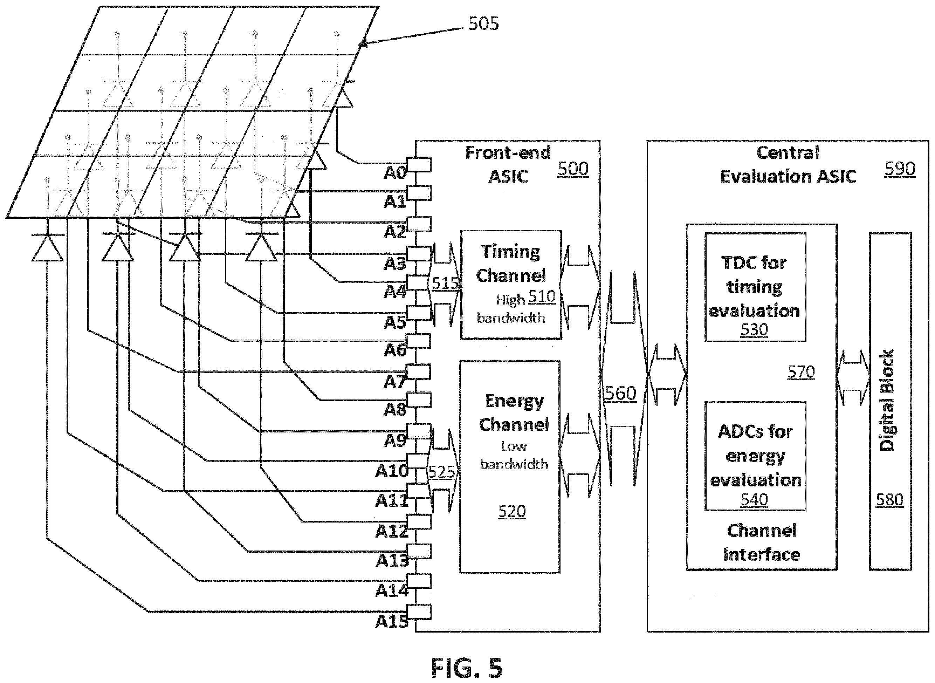

Figure 5 is an example of a simplified block diagram of a split-chip circuit according to an embodiment of the present invention. It should not, however, unduly limit the scope of the claims. One of ordinary skill in the art would recognize many variations, alternatives, and modifications. In an embodiment, the split-chip circuit architecture is provided by packaging a front-end block 500 and a central evaluation block 590 either as a system-on-chip in a package, or as two chips connected on a single printed circuit board (PCB). This helps to suppress ground bouncing that the evaluation circuit can produce, as well as electrical cross talk from one front-end to another.

In an embodiment, front-end block 500 is similar to the front-end circuit 200 in Figure 2. Front-end block 500 includes multiple input ports A0 through A15, which connect to multiple detectors 505 to receive multiple input signals induced by a detected event pulse. Front-end block 500, as an example, is configured in a split-band architecture, with a fast front-end (or timing path) for handling high-frequency signal components of the input signals for some flexibly selected channels and a slow front-end (or energy path) for handling low-frequency signal components of the input signals for some flexibly selected channels. The fast front-end comprises a first interface circuit 515 coupled to a timing channel circuit 510, whereas the slow front-end comprises a second interface circuit 525 coupled to an energy channel circuit 520. First interface circuit 515 selects a first plurality of channels, generating a high-frequency signal component for each selected channel and summing them into a first intermediate signal. Timing channel circuit 510 then processes the first intermediate signal, thus evaluating the timing information carried therein. Second interface circuit 525, in parallel, selects a second plurality of channels and produces a low-frequency signal component for each selected channel, outputting a second intermediate signal per channel. Finally, energy channel circuit 520 processes the second intermediate signal for each selected channel, thus evaluating the energy information carried therein.

Central evaluation block 590 of the split-chip design, as an example, includes a first evaluation circuit block 530 for timing evaluation and a second evaluation circuit block 540 for energy evaluation. Both of these blocks are packaged on a channel interface 560 for coupling with a digital logic circuit block 580. Central evaluation block 590 is coupled with the front-end block 500 via the zone interface 560, which is a timing and energy interface for handling signals respectively from the timing channel circuit 510 and energy channel circuit 520. In an embodiment, only the front-end block is connected directly to the detectors (e.g., SiPMs), thus decoupling it from any other circuitry that may not work in synchrony with the event pulse detection. The split-chip architecture in this embodiment allows for virtually infinite local ground bouncing of the front-end amplifier, which may be essential for low-noise timing detection (e.g. required for PET scanners).

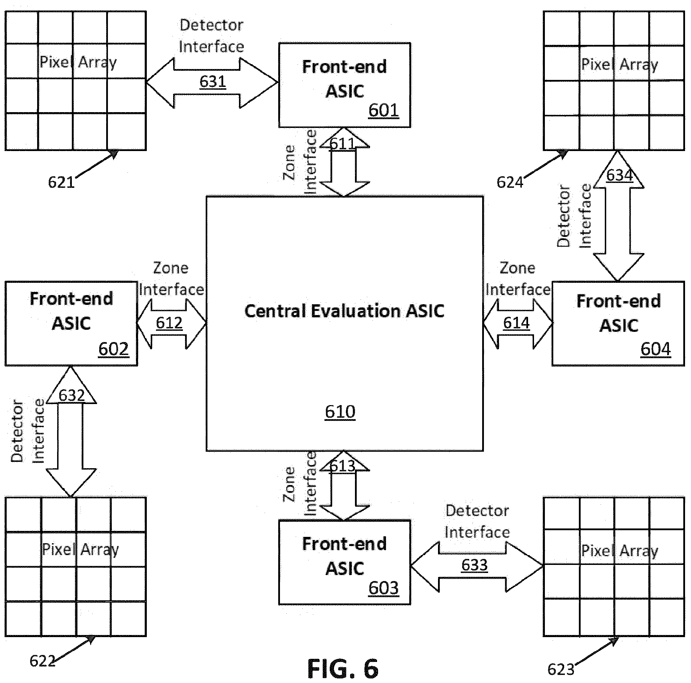

Figure 6 is a simplified block diagram of multiple front-end circuits sharing one central evaluation circuit according to an embodiment of the present invention. This diagram is merely an example, which should not unduly limit the scope of the claims. One of ordinary skill in the art would recognize many variations, alternatives, and modifications. In some embodiments, the split-chip approach is further expanded to provide an architecture with one central evaluation circuit shared by several front-end circuits. Figure 6 shows an example of four front-end circuits 601, 602, 603, and 604 connected to one central evaluation circuit 610 via respective zone interfaces 611, 612, 613, and 614. Four front-end circuits 601, 602, 603, and 604 are connected respectively with four detector arrays 621, 622, 623, and 624 via respective four detector interfaces 631, 632, 633, and 634. For example, each front-end circuit is configured to be similar to or the same as front-end circuit 200 of Figure 2 or front-end block 500 of Figure 5 to provide flexible-channel split-band timing and energy signals respectively based on four event pulses respectively detected by the four detector arrays. Central evaluation circuit 610 is configured to be substantially like central evaluation block 590 of Figure 5. Central evaluation circuit 610 may be capable of handling 64 channels for simultaneous timing and energy evaluation. The proposed front-end architecture allows for the central evaluation ASIC to be designed using a cost-effective technology, while the front-end ASICs can be manufactured using highly advanced very deep submicron CMOS technology and/or bipolar transistors that are available in BiCMOS processes. This approach enables the optimization of both power consumption and fabrication costs for the overall system.

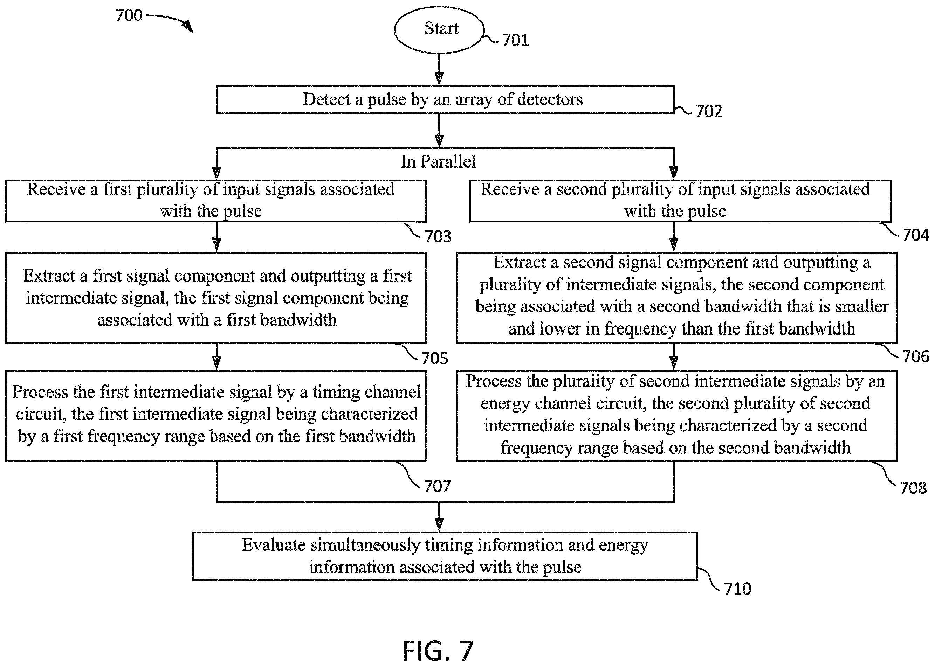

Figure 7 is a simplified flow diagram of a method for timing and energy extraction according to embodiments of the present invention. This diagram is merely an example, which should not unduly limit the scope of the claims. One of ordinary skill in the art would recognize many variations, alternatives, and modifications. As shown, method 700 starts at step 701 with a split-band operation for extracting timing and energy information about a detected event pulse. Method 700 include step 702 for detecting a pulse by an array of detectors. For example, in a ToF application like a PET scanner, step 702 is initiated by exposing SiPMs detector to scintillators that convert gamma rays into light in the wavelength range that the SiPMs can detect. In another example for a LiDAR, step 702 is executed by using its SiPM or APD array to detect reflected pulses of a laser pulse from an emitter. The PET scanner uses the time-of-flight (ToF) principle to detect the location where an event happened by comparing the detection events of two 511keV gamma quanta produced at the same time by an electron-positron annihilation and travelling in opposite directions. For the LiDAR, the time between the laser pulse has been sent out and the reflected pulse gets detected multiplied by the speed of light amounts to double the distance of the object. The energy of the event pulse can be measured by integrating the event pulse over time.

Referring to Figure 7, method 700 further is implemented in the split-band operation by a front-end device with two circuitry paths configured in parallel for processing high-band signals in a first path and low-band signals in a second path. Method 700 includes, in a first operation path, step 703 for receiving a first plurality of input signals by a first plurality of input ports coupled to a first plurality of channels. Each input signal is an electrical signal converted from a portion of optical signal detected by one detector of the detector array. The first plurality of channels includes a first number of channels selected from 1 to N, where N is a total number of detectors in the array of detectors. In parallel in a second operation path, method 700 includes step 704 for receiving a second plurality of input signals by a second plurality of input ports coupled to a second plurality of channels. The second plurality of channels includes a second number of channels selected from 1 to N. The second number and the first number are independent and flexibly selected when implementing the method depending on system design options for different ToF applications.

Further in the first operation path, method 700 includes step 705 for extracting a first signal component for each of the first plurality of input signals and outputting a first intermediate signal. The first signal component is associated with a first bandwidth of the first plurality input signals. This step is implemented in the first circuitry path of the front-end device by using a high-pass filter to process the input signal for each channel to extract the first signal component in the first bandwidth having a low bound frequency. The first circuitry path is a high-speed path of the front-end device. This step is implemented also by having a multiplexer to sum up all first signal components for the first plurality of channels to provide the first intermediate signal. Further in the second path, method 700 includes step 706 for extracting a second signal component for each of the second plurality of input signals and outputting a plurality of intermediate signals. The low-band component is associated with a second bandwidth of the second plurality of input signals. The second bandwidth has a smaller and lower frequency band than the first bandwidth. This step is implemented in the second circuitry path of the front-end device by using a bandpass filter or low-pass filter to process the input signal for each channel to extract the second signal component in the second bandwidth having a high bound frequency. The high bound frequency of the second bandwidth is lower than the low bound frequency of the first bandwidth. The second circuitry path is a low-speed path of the front-end device.

For a PET scanner with a very low incident rate, a single channel in high-speed path would be sufficient, but all pixel energies and locations should be monitored to classify each signal. For a Lidar sensor, the number of selected channels could be optimized either in a similar way, for example, if the laser is illuminating only a fraction of the pixels at a certain time. the number of selected channels for high-speed path can also be chosen higher than the number of selected channels for slow-speed path, for example, if the spatial resolution for energy classification can be chosen smaller than the spatial resolution of the ToF distance measurements. With the flexible channel selection option, the high-speed path and low-speed path of the front-end circuit can be separately designed to achieve best system optimization with great saving in power consumption and cost.

Referring to Figure 7, method 700 further, in the first operation path, step 707 for processing the first intermediate signal in a timing channel circuit characterized by a first frequency range based on the first bandwidth. In parallel, method 700 includes step 708 in the second operation path for processing the second plurality of second intermediate signals in an energy channel circuit characterized by a second frequency range based on the second bandwidth. Step 707 is implemented in the timing channel circuit in the high-speed path of the front-end device. In an embodiment, step 707 may include performing undistorted signal amplification using a trans-impedance amplifier or operational amplifier in a timing channel circuit of the front-end device. Step 708 is implemented in the energy channel circuit in the low-speed path of the front-end device. In an embodiment, step 708 may include performing integration of each of the second intermediate signal over time using an integral amplifier to extract energy content in the signal. For obtaining better spatial resolution of the event pulse on the pixel array of the detector, all high-band signal components may be collected for discriminate the detector locations on the array (where the pulse landed) for more detailed characterization of the event. The first intermediate signal or each of the second plurality of second intermediate signals is still an analog signal. Yet, the first intermediate signal typically has a narrow intensity peak in time axis while the second intermediate signal has a broad peak over wide time span.

Referring to Figure 7 again, method 700 additionally include step 710 for evaluating simultaneously timing information and energy information about the pulse respectively based on outputs of step 707 and step 708. In an embodiment, step 710 includes performing a time-to-digital conversion to the output (e.g., a time duration in a form of an analog signal) of step 707 for evaluating timing information about the event pulse. Step 710 also includes performing analog-to-digital conversion to the output (e.g., an energy content in a form of analog signal) of step 708 for evaluating energy information about the event pulse. Optionally, step 710 is executed in a first evaluation circuit having a one-channel time-to-digital converter (TDC) and a second evaluation circuit having multiple analog-to-digital converters (ADCs) in the same front-end device. Optionally, step 710 is executed in an evaluation circuit coupled to the front-end device, the evaluation circuit containing the first evaluation circuit and the second evaluation circuit. Optionally, step 710 may further include extracting the timing and energy information about the event pulse at the same time. Step 710 may be implemented in a digital logic circuit containing at least a digital signal processor. Optionally, method 700 may be executed in a system-on-chip (SOC) ASIC co-packaged with at least a split-band front-end circuit, a first evaluation circuit, a second evaluation circuit, and a digital logic circuit. Optionally, method 700 may be executed in two split-chip ASIC with a first ASIC component containing a split-band front-end circuit non-synchronously coupled with a second ASIC component containing an evaluation circuit including a first evaluation circuit block, a second evaluation circuit block, and a digital logic circuit block, etc.

While the above is a full description of the specific embodiments, various modifications, alternative constructions and equivalents may be used. Therefore, the above description and illustrations should not be taken as limiting the scope of the present invention which is defined by the appended claims.

## Claims

1. An apparatus comprising:
a first plurality of input ports coupled to a first plurality of channels configured to receive a first plurality of input signals;
a second plurality of input ports coupled to a second plurality of channels configured to receive a second plurality of input signals;
a first interface circuit configured to extract first signal components in a first bandwidth selected from the first plurality of input signals and output a first intermediate signal;
a second interface circuit configured to extract second signal components in a second bandwidth selected from the second plurality of input signals and output a plurality of second intermediate signals, the second bandwidth being smaller and lower in frequency than the first bandwidth;
a first channel circuit coupled to the first interface circuit and configured to process the first intermediate signal; and
a second channel circuit coupled to the second interface circuit and configured to process the plurality of second intermediate signals.

2. The apparatus of claim 1, wherein
the first plurality of channels comprises M channels selected from 1 to N, N being a number of all input ports,
the second plurality of channels comprises L channels selected from 1 to N, M and L are independent whole numbers.

3. The apparatus of claim 2, wherein
the first plurality of input signals and the second plurality of input signals are based on a pulse detected by an array of N detectors respectively coupled to N input ports.

4. The apparatus of claim 2 or 3, wherein
the plurality of second intermediate signals comprises the second signal components associated with the L channels.

5. The apparatus of any one of the claims 2 to 4, wherein
the first interface circuit comprises a high-pass filter and a multiplexer,
the high-pass filter being configured in series with the input ports to extract the first signal components from the M channels,
the multiplexer being configured to sum up the first signal components for the M channels; wherein in particular
the high-pass filter comprises a capacitor **characterized by** a capacitance value associated with the first bandwidth.

6. The apparatus of any one of the claims 2 to 5, wherein
the second interface circuit and the first interface circuit are configured in parallel with one another.

7. The apparatus of any one of the claims 1 to 6, wherein
the first channel circuit comprises a trans-impedance amplifier configured to convert the first intermediate signal to a voltage signal.

8. The apparatus any one of the of claims 1 to 7, wherein
the second interface circuit comprises a DC-coupling circuit configured to be a low-pass filter to filter out frequencies above the second bandwidth of the second plurality of input signals to obtain the second signal components.

9. The apparatus of claim 4, wherein
the second channel circuit comprises L integral amplifiers, each of the L integral amplifiers being configured to integrate the second signal components over a time period.

10. The apparatus of any one of the claims 1 to 9, wherein
the second interface circuit comprises a bandpass filter to filter out frequencies beyond the second bandwidth of the second plurality of input signals to obtain the second signal components.

11. The apparatus of claim 3, further comprising:
a first evaluation circuit coupled to the first channel circuit, the first evaluation circuit comprising at least a time-to-digital converter operating at a first frequency range, the first frequency range being based on the first bandwidth;
a second evaluation circuit coupled to the second channel circuit, the second evaluation circuit comprising a plurality of analog-to-digital converters operating at a second frequency range, the second frequency range being based on the second bandwidth; and
a digital logic circuit comprising a digital signal processor or field-programmable gate array circuit configured to extract timing information associated with the pulse based on outputs of the first evaluation circuit and extract energy information associated with the pulse based on outputs of the second evaluation circuit;
wherein in particular
the plurality of analog-to-digital converters are configured as a multi-channel analog-to-digital converter having a number of channels equal to total number of the second plurality of channels;
and/or
the apparatus further comprises a channel interface coupled to the first evaluation circuit and the second evaluation circuit.

12. An apparatus comprising:
one or more front-end devices each configured to couple to a respective of one or more arrays of detectors, each of the one or more front-end devices comprising:
a first plurality of input ports coupled to a first plurality of channels configured to receive a first plurality of input signals based on a pulse detected by a respective one of the one or more arrays of detectors;
a second plurality of input ports coupled to a second plurality of channels configured to receive a second plurality of input signals based on the detected pulse;
a first interface circuit configured to extract first signal components in a first bandwidth of the first plurality of input signals and output a first intermediate signal;
a second interface circuit configured to extract second signal components in a second bandwidth of the second plurality of input signals and to output a plurality of second intermediate signals, the second bandwidth having a smaller and lower frequency band than the first bandwidth;
a first channel circuit coupled to the first interface circuit and configured to process the first intermediate signal; and
a second channel circuit coupled to the second interface circuit and configured to process the plurality of second intermediate signals; and
a central evaluation device coupled to the one or more front-end devices, the central evaluation device comprising:
a first evaluation circuit comprising at least a time-to-digital converter (TDC) configured to evaluate timing information associated with the pulse using at least an output of the first channel circuit of a respective one of the one or more front-end devices;
a second evaluation circuit comprising at least the second plurality of analog-to-digital circuits (ADCs) configured to evaluate energy information associated with the pulse using at least a plurality of outputs of the second channel circuit of the respective one of the one or more front-end devices; and
a digital logic circuit coupled to the first evaluation circuit and the second evaluation circuit and configured to extract the timing information and the energy information associated with the pulse.

13. The apparatus of claim 12, wherein
the central evaluation device operates asynchronously with the one or more front-end devices;
and/or
the one or more front-end devices and the central evaluation device are separate chip components configured to mount on a single printed circuit board.

14. A method for obtaining timing and energy information, the method comprising:
receiving a first plurality of input signals associated with a pulse detected by an array of detectors;
receiving a second plurality of input signals associated with the detected pulse;
obtaining a first signal component for each of the first plurality of input signals and outputting a first intermediate signal, the first signal component being associated with a first bandwidth;
obtaining a second signal component for each of the second plurality of input signals and outputting a plurality of second intermediate signals, the second signal component being associated with a second bandwidth, the second bandwidth being smaller and in lower frequency band than the first bandwidth;
processing the first intermediate signal by a timing channel circuit, the first intermediate signal being **characterized by** a first frequency range, the first frequency range being based on the first bandwidth;
processing the plurality of second intermediate signals by an energy channel circuit, the plurality of second intermediate signals being **characterized by** a second frequency range, the second frequency range being based on the second bandwidth; and
evaluating timing information associated with the detected pulse using at least an output of the timing channel circuit and energy information associated with the detected pulse using at least outputs of the energy channel circuit.

15. The method of claim 14, further comprising
amplifying the first intermediate signal by a transimpedance amplifier; and/or
filtering the first plurality of input signals.
